# EUROPÄISCHE PATENTANMELDUNG

(11) **EP 1 358 995 A2**
(43) Veröffentlichungstag der Anmeldung: **05.11.2003**
(21) Anmeldenummer: 03090093.0
(22) Anmeldetag: 04.04.2003
(51) Int. Cl.: B29C 70/62, H05K 9/00, F16J 15/14, B29C 67/00, B29C 69/02

(54) **Elektrisch leifähige Dichtung sowie Verfahren und Vorrichtung zu deren Herstellung**

(30) Priorität: 03.05.2002 DE 10221100
(71) Anmelder: Neuhaus Elektronik GmbH, 13359 Berlin (DE)
(72) Erfinder: Neuhaus, Alexander, Dipl.-Ing., 13467 Berlin (DE)
(74) Vertreter: Wablat, Wolfgang, Dr.Dr.

(57) **Zusammenfassung**

Eine elektrisch leitfähige Dichtung (1), die durch Extrusion eines mit leitenden Teilchen vermischten elastisch aushärtenden Materials unmittelbar auf eine erste Dichtfläche (5) gebildet wird, ist zusätzlich mit magnetischen Teichen vermischt. Durch eine nach dem Aufbringen auf die erste Dichtfläche (5) von einer elektromagnetischen Platte (7) ausgehende magnetische Kraft, die auf den an der Außenfläche ausgehärteten, aber ansonsten noch plastischen Dichtstrang wirkt, wird das Querschnittsprofil auf eine einstellbare Höhe zu einer zweiten Dichtfläche hin gestreckt und/oder es können Dichtlippen (3,9) angeformt werden. Die magnetischen und leitfähigen Teilchen sind vorzugsweise im Randbereich konzentriert, und zwar insbesondere durch bei der Extrusion auf den Dichtungsstrang wirkende Magnetkräfte.

## Beschreibung

Elektrisch leitfähige Dichtung sowie Verfahren und Vorrichtung zu deren Herstellung

Die Erfindung betrifft ein Verfahren und eine Vorrichtung zur Herstellung einer elektrisch leitfähigen Dichtung aus einem mit leitfähigen Partikeln vermischten elastisch aushärtenden Material, das aus einem Extruder in noch nicht ausgehärtetem Zustand auf eine erste Dichtfläche aufgetragen wird, sowie eine nach dem Verfahren hergestellte Dichtung.

Es ist bekannt, dass elektronische Bauteile elektromagnetische Störsignale erzeugen, die durch Spalte der Gehäuse, in denen die elektronischen Bauteile untergebracht sind, nach außen gelangen und über Signalleiter auf andere elektronische Bauteile, und zwar wieder durch Spalte des diese aufnehmenden Gehäuses, übertragen werden und zu Beschädigungen und Fehlfunktionen der anderen elektronischen Bauteile führen können.

Um zu verhindern, dass die als Störsignal wirkenden elektromagnetischen Wellen aus einem Gehäuse austreten und in ein anderes Gehäuse eindringen und damit die Funktion elektronischer Bauteile beeinträchtigen können, werden die den Spalt des Gehäuses bildenden Oberflächen (Dichtflächen) durch eine elektrisch leitfähige Dichtung gegeneinander abgedichtet. Das ebenfalls leitfähig ausgebildete Gehäuse wirkt in Verbindung mit der leitfähigen Dichtung als Faradayscher Käfig, um so die Abstrahlung elektromagnetischer Wellen zu verhindern bzw. elektronische Bauteile gegen störende Strahlungseinwirkung abzuschirmen.

Neben der Abschirmung elektromagnetischer Störstrahlen aufgrund der Leitfähigkeit des verwendeten Materials besteht eine weitere wesentliche Funktion derartiger Dichtungen im Schutz der elektronischen Vorrichtung vor der Einwirkung von Schmutzpartikeln, Feuchtigkeit und toxischen Gasen. Die elektronische Dichtung muss somit gleichzeitig den an eine in der Bautechnik und im Maschinenbau üblicherweise angewendete Sperrdichtung zur Verhinderung des Stoffaustausches zwischen zwei Räumen zu stellenden Anforderungen genügen.

Bei dem eingangs erwähnten Verfahren hat die frisch extrudierte Dichtung einen im Wesentlichen kreisrunden Querschnitt. Diese Querschnittsform wird nach dem Auftragen auf die Dichtfläche eines Gehäuseteils oder eine andere Unterlage aufgrund ihres Eigengewichts und des anfangs noch plastischen Zustands während der Aushärtungsperiode noch geringfügig abgeflacht. Zwar sind die elektronischen Abschirmeigenschaften einer derartigen Dichtung ausreichend hoch, jedoch genügen die elastischen Eigenschaften aufgrund der hohen Verfestigung durch die über den gesamten Querschnitt verteilten leitenden Partikel nicht höchsten Anforderungen in Bezug auf die stoffliche Abdichtung. Da die leitenden Partikel aus Silber oder aus versilbertem Material bestehen, sind die so ausgebildeten Dichtungen zudem verhältnismäßig teuer.

In der DE 197 33 627 wird bereits eine elektronische Dichtung vorgeschlagen, die bei vermindertem Gehalt an teuerem Silber und dennoch gleichbleibend guter elektronischer Abschirmwirkung über deutlich verbesserte elastische Eigenschaften zur stofflichen Abdichtung verfügt. Diese Dichtung besteht aus einem innenliegenden Dichtstrang aus von leitenden Partikeln freiem, elastisch aushärtenden Material und aus einem diesen als dünner Überzug umhüllenden Leitmittelstrang aus mit leitenden Partikeln versetztem aushärtenden Material.

Die Herstellung der Dichtung aus zwei unterschiedlichen Stoffen bzw. Stoffgemischen durch Koextrusion ist zum einem mit hohen Werkzeugkosten verbunden, und andererseits kann die scharfe Trennung zwischen der sehr elastischen Innenschicht und der weniger elastischen, spröden Außenschicht und das unterschiedliche Aushärtungsverhalten zu Rissbildungen in der Dichtung führen. Eine bestimmte Abflachung der Dichtung während der Aushärtung des Innenstranges ist nicht zu vermeiden, so dass sich die Elastizität verringert und ein enges elastisches Anliegen der Dichtung an den gegenüberliegenden Dichtflächen nicht in jedem Fall gewährleistet ist. Andererseits ist bei dieser Art von elektronischen Abschirmdichtungen eine von der kreisrunden Profilierung abweichende Querschnittsform der Dichtung zur Erzeugung höherelastischer Querschnitte oder Querschnittsbereiche mit einem unvertretbar hohen Aufwand für die Ausbildung der Extrusionswerkzeuge verbunden oder technisch nicht realisierbar.

Mit den bekannten elektrisch leitfähigen Dichtungen gelingt es insbesondere nicht, die in der Massenfertigung aufgrund von Fertigungstoleranzen oftmals auftretenden Unterschiede in der Dichtspalthöhe auszugleichen, da das extrudierte Dichtungsmaterial für jede Dichtung im wesentlichen immer in ein und derselben Abmessung dimensioniert ist und eine Veränderung des Durchmessers mit höheren Werkzeug- und insbesondere Materialkosten verbunden ist. Andererseits kommt es häufig vor, dass am Anfang und am Ende jedes Extrusionsvorganges, das heißt, an der Stelle, an der die beiden Dichtungsenden aneinander stoßen, eine größere Menge Dichtungsmittel auf die Dichtfläche aufgebracht wird. In beiden Fällen ist die Dichtwirkung der elektrisch leitfähigen Dichtung beeinträchtigt.

In manchen Fällen ist die Dichtspalthöhe auch so groß, dass zur Erzielung einer bestimmten Höhe der Dichtung in zwei aufeinanderfolgenden Arbeitsgängen zwei Dichtungen übereinander auf die Dichtfläche extrudiert werden müssen. Ein zwei- oder gar mehrfaches Übereinanderlegen der Dichtungsstränge ist nicht nur zeitaufwendig, sondern auch mit erhöhten Materialkosten verbunden.

Der Erfindung liegt daher die Aufgabe zugrunde, elektrisch leitfähige Dichtungen der eingangs erwähnten Art so auszubilden und herzustellen, dass eine hohe Elastizität der Dichtung gewährleistet ist und Toleranzen in der Dichtspalthöhe und/oder der Höhe des extrudierten Dichtungsmaterials an der Verbindungsstelle der beiden Strangenden ausgeglichen werden und bei verringertem Arbeits- und Materialaufwand eine sichere stoffliche Abdichtung und elektronische Abschirmung gewährleistet ist.

Erfindungsgemäß wird die Aufgabe mit einem nach den Merkmalen des Patentanspruchs 1 arbeitenden Verfahren gelöst. Die Ausbildung der Vorrichtung zur Durchführung des Verfahrens und die auf die erfindungsgemäß hergestellte Dichtung bezogenen Merkmale ergeben sich aus den Ansprüchen 17 bzw. 22.

Vorteilhafte Weiterbildungen und zweckmäßige Ausgestaltungen der Erfindung sind in den Unteransprüchen aufgeführt.

Bei einem Verfahren zur Herstellung einer elektrisch leitfähigen Dichtung, die aus mit elektrisch leitenden Teilchen vermischtem, elastisch aushärtendem Material besteht, das nach der Extrusion in noch plastischem Zustand mit im Wesentlichen runder Querschnittsform unmittelbar auf eine Dichtfläche eines Gehäuses aufgetragen wird, besteht der wesentliche Erfindungsgedanke darin, dass das elastisch aushärtende Material vor der Extrusion zusätzlich mit magnetischen Teilchen vermischt wird und der extrudierte, auf einer ersten Dichtfläche haftende magnetische Dichtungsstrang von den magnetischen Kräften einer auf oder oberhalb des an der Außenfläche bereits ausgehärteten Dichtungsstranges angeordneten elektromagnetischen Platte angezogen und dabei verformt wird. Durch die Anordnung der elektromagnetischen Platte in einer bestimmten Höhe über dem Dichtungsstrang oder das Anheben der an der Dichtung liegenden elektromagnetischen Platte und/oder durch eine dem Verlauf des Dichtungsstranges folgende, in der elektromagnetischen Platte ausgebildete Profilierung in Form mindestens einer nutartigen Vertiefung wird der im Innern noch plastische, aber an der ersten Dichtfläche haftende Dichtungsstrang zur elektromagnetischen Platte bzw. einer gegenüberliegenden zweiten Dichtfläche hin gestreckt. Durch das Strecken des im wesentlichen runden Querschnitts senkrecht zur Längsrichtung des Dichtungsstranges und insbesondere durch die Ausbildung mindestens einer der Profilierung in der elektromagnetischen Platte entsprechenden Dichtlippe wird die Elastizität der so ausgebildeten Dichtung deutlich verbessert. Infolge der Höhenverstellbarkeit bzw. der Einstellbarkeit der elektromagnetischen Platte auf ein bestimmtes Niveau über der ersten Dichtfläche kann die Höhe (Streckung) der Dichtung den Fertigungsbedingungen entsprechend eingestellt werden. Es können aber nicht nur Toleranzen in Bezug auf die Dichtspalthöhe, sondern auch hinsichtlich der Höhe des Dichtungsstranges ausgeglichen werden. Ein weiterer wichtiger Vorteil besteht schließlich darin, dass zur Erzielung einer für das Ausfüllen eines sehr großen Dichtspaltes und der dazu notwendigen großen Höhe der Dichtung beim Extrudieren des Dichtstranges nicht mehr ein besonders dicker Strang aufgetragen oder mehrere Stränge übereinandergelegt werden müssen, sondern eine einzige Lage auf die erforderliche Höhe gestreckt werden kann. Dadurch wird der Arbeits- und Materialaufwand gesenkt.

Es versteht sich, dass mit dem Begriff Extrusion hier jegliche Art der sich unter Druckwirkung vollziehenden Ausgabe eines in plastischem Zustand vorliegenden Dichtungsmaterials auf eine Dichtfläche gemeint ist, Das heißt, die Zuführung des Dichtungsmaterials zu einer Düse oder einem Extruderkopf kann mit einer Schneckenpresse, einer Kolbenpumpe, einer Zahnradpumpe, unter bloßem Luftdruck und dgl. mehr erfolgen.

In vorteilhafter Weiterbildung der Erfindung sind die magnetischen und die leitenden Teilchen als miteinander verbundene - einstückige - Partikel ausgebildet, das heißt, die magnetischen Eisen- oder Nickelteilchen (oder Teilchen aus anderem magnetischen Material) sind mit einer elektrisch leitfähigen Schicht überzogen. Bei der Extrusion können diese Teilchen durch Anlegen magnetischer Kräfte in den Randbereich des extrudierten Dichtungsstranges gezogen werden, um so mit einem geringen Materialanteil die Leitfähigkeit am Rand der Dichtung zu erhöhen und gleichzeitig die Elastizität im Innern der Dichtung zu verbessern und schließlich einen homogenen Übergang zwischen dem hochelastischen inneren Bereich und dem leitfähigen Außenbereich der Dichtung zu schaffen. Da der Anteil an elastisch aushärtendem Material in diesem Fall am Umfangsrand des extrudierten Dichtungsstranges gering ist, härtet die Außenfläche schnell aus, so dass nach dem darauffolgenden Strecken des Dichtungsstranges bzw. beim Anformen einer Dichtlippe die Dichtung leicht von der elektromagnetischen Platte lösbar ist. Die - einstückigen - leitenden und magnetischen Teilchen können aber auch nur aus Nickel, das sowohl leitfähig als auch magnetisch ist, bestehen. Neben den separaten oder einstückigen magnetischen und einstückigen magnetischen und leitenden Teilchen kann das Dichtungsmaterial aber auch einstückige leitende und magnetische und darüber hinaus leitfähige nichtmagnetische Teilchen enthalten. Die leitfähigen magnetischen Teilchen können in Form von Fasern oder Plättchen vorliegen.

Es ist aber auch denkbar, dass durch Koextrusion ein von magnetischen und leitenden Teilchen freier Innenstrang aus elastisch aushärtendem Material, der von einer dünnwandigen Umhüllung aus mit leitenden und mit magnetischen Teilchen vermischtem, elastisch aushärtenden Material umhüllt ist, auf die erste Dichtfläche aufgetragen wird. Auch in diesem Fall ist es vorteilhaft, wenn in der koextrudierten äußeren Leithülle mit einer leitenden Schicht umhüllte magnetische Teilchen verwendet werden. In diesem Fall kann auch ein sehr geringer Anteil an magnetischen Teilchen in den Innenstrang eingemischt sein.

In weiterer Ausbildung der Erfindung kann die elektromagnetische Platte zur Erzielung unterschiedlicher Verformungskräfte und unterschiedlicher Streckung des Querschnitts im Verlauf des Dichtstranges in einzelne Magnetsegmente eingeteilt sein, die einzeln ansteuerbar sind. Schließlich ist es auch denkbar, mit einer seitlich zum Gehäuse/Dichtstrang angeordneten elektromagnetischen Platte auch eine seitliche Verformung des Dichtstranges vorzunehmen. Der Dichtstrang kann auch als Hohlkörper extrudiert werden, wobei dessen Form nach dem Extrudieren durch die Magnetkräfte gehalten bzw. verändert wird.

Die Erfindung ist nicht nur im Bereich der Abschirmdichtungen anwendbar, sondern kann auch zur Verformung anderer, auf einer Dichtfläche aushärtender Dichtungen angewendet werden.

Ausführungsbeispiele der Erfindung werden anhand der beigefügten Zeichnung näher erläutert, wobei Ausgangspunkt der erfindungsgemäßen Behandlung zur Verbesserung der Elastizität und zum Toleranzausgleich eine Dichtung mit im Umfangsrandbereich angereicherten elektrisch leitfähigen Partikeln ist. Es zeigen:
- Fig. 1: eine schematische Darstellung der Herstellung einer Dichtung gemäß dem erfindungsgemäßen Verfahren mit Hilfe einer elektromagnetischen Platte mit an deren Unterseite ausgebildeter, dem Dichtungsverlauf folgender, etwa halbkreisförmiger Profilierung und in deren Verlauf angeordneten Elektromagneten;
- Fig. 2: das Verfahren nach Fig. 1, jedoch mit zwei Dreieck-Profilnuten in der elektromagnetischen Platte zur Ausbildung eines Dichtungsstranges mit zwei nebeneinander liegenden Dichtungslippen;
- Fig. 3: eine weitere Variante der Ausbildung der Profilnut in der elektromagnetischen Platte zur Herstellung von Dichtungen mit unterschiedlich geformten Dichtungslippen;
- Fig. 4: eine weitere Verfahrensvariante, bei der der Dichtungsstrang durch ein etwa kreisförmiges Dichtungsteil erweitert wird und die Querschnittsform mit einer seitlich angeordneten Magnetplatte auch seitlich verformt wird; und
- Fig. 5: eine weitere Verfahrensvariante, bei der eine ein etwa quadratisch ausgebildeter Dichtstrang durch die Druckwirkung einer profilierten elektromagnetischen Platte verformt wird.

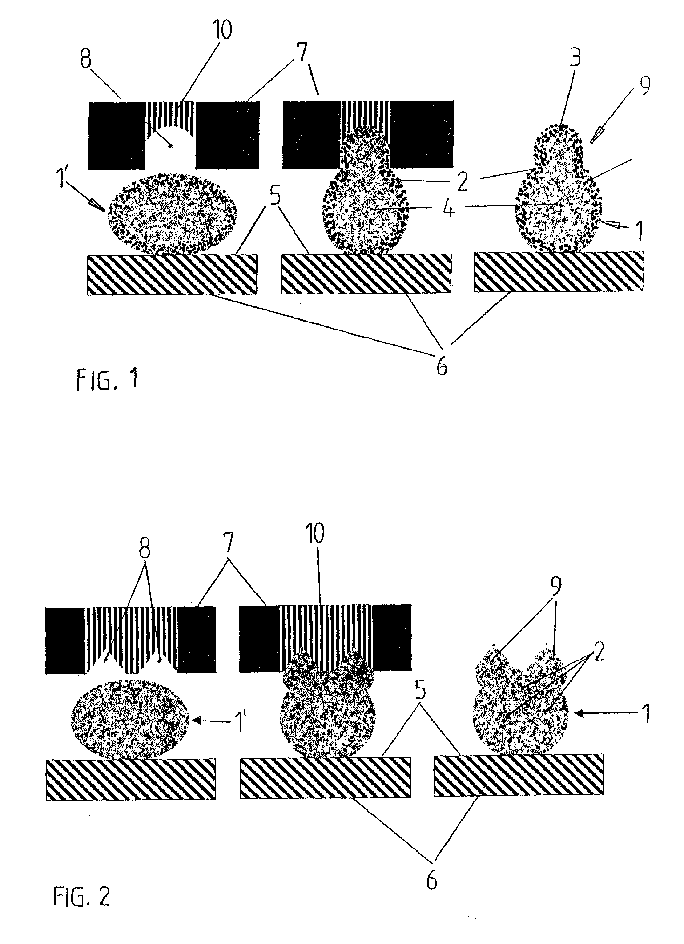

Jede der in den Figuren 1 bis 5 dargestellten Dichtungen 1 bzw. jeder der Dichtstränge 1' besteht aus einem bei Raumtemperatur oder bei höherer Temperatur oder unter Einwirkung ultravioletter Strahlen elastisch aushärtenden Material, hier einem Silikon, das mit elektrisch leitfähigen, magnetischen Teilchen 2 vermischt ist. Die elektrisch leitfähigen, magnetischen Teilchen 2 sind - im Ausführungsbeispiel - mit einer Silberschicht ummantelte Partikel aus Nickel oder Eisen und haben daher magnetische Eigenschaften und eine hohe Leitfähigkeit. Die elektrisch leitfähigen, magnetischen Teilchen 2 befinden sich vorzugsweise überwiegend im Randbereich der Dichtung 1/des Dichtstranges 1', so dass ein gut leitfähiger und außerdem magnetischer schmaler Außenring 3 und ein von leitfähigen, magnetischen Partikeln im Wesentlichen freier Innenstrang 4 gebildet werden. Diese Verteilung der leitfähigen, magnetischen Partikel wird gemäß der Erfindung so erreicht, dass das mit den leitfähigen, magnetischen Teilchen 2 vermischte, noch plastische Dichtungsmaterial während oder nach der Extrusion durch eine ringförmig angeordnete Magnetgruppe läuft, die am oder um den Extruderkopf eines Extruders ( jeweils nicht dargestellt) angeordnet ist. Dadurch werden die leitfähigen, magnetischen Teilchen zum größten Teil in den Randbereich der Dichtung 1 gezogen, um den schmalen, mit leitfähigen, magnetischen Teilchen stark angereicherten Außenring 3 der Dichtung 1 zu bilden, während der Innenstrang 4 frei von leitfähigen, magnetischen Teilchen 2 wird oder nur zu einem geringen Teil mit leitfähigen, magnetischen Teilchen 2 versetzt ist.

Es ist - abweichend von dem oben beschriebenen Ausführungsbeispiel - aber auch denkbar, dass der angereicherte Randbereich in bekannter Weise durch Koextrusion eines mit leitfähigen und magnetischen Teilchen vermischten und eines von leitfähigen und magnetischen Teilchen freien Materials erzeugt wird, wobei das mit leitenden Partikeln vermischte Material einen den leitmittelfreien Innenstrang umhüllenden, aber magnetischen Leitmittelstrang bildet.

Es ist insbesondere weiterhin möglich, dass der Dichtstrang über seinen gesamten Querschnitt homogen mit den elektrisch leitfähigen, magnetischen Teilchen durchmischt ist oder der Innenstrang einen geringeren Teil der insgesamt erforderlichen leitfähigen und magnetischen Teilchen erhält, die beim Extrudieren durch die magnetischen Kräfte in den äußeren Randbereich gezogen werden.

Die frisch extrudierte Dichtstrang 1' für die Dichtung 1 wird in noch plastischem Zustand auf eine erste Dichtfläche 5 eines Gehäuseteils 5, das mit einem oberen Gehäuseteil mit zweiter Dichtfläche (nicht dargestellt) ein Gehäuse mit einem zwischen den Dichtflächen der beiden Gehäusehälften liegenden Dichtspalt bestimmter Höhe bildet, aufgetragen. Gemäß den Figuren 1 bis 4 hat der frisch extrudierte Dichtstrang 1' für die Dichtung 1 zunächst eine kreisrunde und nach dem Ablegen auf die erste Dichtfläche 5 etwas abgeflachte Querschnittsform. Die zuerst aushärtende Außenfläche des Dichtstranges 1' verbindet sich in der noch plastischen Phase nach der Extrusion mit der Dichtfläche 5 des Gehäuseteils 6, härtet aber ansonsten schnell aus, da hier die Aushärtungsparameter - Raumtemperatur und Luftfeuchtigkeit, UV-Strahlung oder erhöhte Temperatur - zuerst wirksam sind und der Anteil an aushärtendem Material wegen der darin gebundenen Teilchen gering ist. Um bei unter erhöhter Temperatur oder unter UV-Strahlung aushärtenden Materialien eine möglichst schnelle Aushärtung der Außenfläche der Dichtung zu bewirken, kann der auf die Dichtfläche 5 aufgetragene Dichtstrang 1' auch kurzfristig einer entsprechenden Wärme- bzw. UV-Strahlung ausgesetzt werden.

Nach dem Aufbringen des Dichtstranges 1' auf die Dichtfläche 5 wird eine elektromagnetische Platte 7 über die untere Gehäusehälfte 6 gefahren und unmittelbar oder in einem bestimmten Abstand über dem Dichtstrang 1' positioniert. In der der Dichtung 1 zugewandten Unterseite der elektromagnetischen Platte 7 ist eine Profilierung 8 in Form einer oder mehrerer Nuten ausgeformt, wobei in der Profilierung 8 hintereinander eine Vielzahl von Elektromagneten 10 angeordnet ist, die einzeln oder in Gruppen ansteuerbar sind. Der Verlauf der Profilierung 8 in der elektromagnetischen Platte 7 entspricht dem der Dichtung 1 bzw. des Dichtstranges 1' auf der umlaufenden Dichtfläche 5. Die eingestellte Höhenposition der elektromagnetischen Platte 7 zuzüglich der Tiefe der Profilierung 8 entspricht der auf der jeweiligen Dichtspalthöhe basierenden Höhe der fertigen - gestreckten und/oder profilierten - Dichtung 1.

Auf die in den Figuren 1 bis 4 dargestellte Profilierung 8 der elektromagnetischen Platte 7 kann auch verzichtet werden, das heißt, die elektromagnetische Platte 7 kann an der Unterseite auch völlig eben ausgebildet sein. In diesem Fall muss die elektromagnetische Platte 7 aber in einem bestimmten Abstand über dem Dichtstrang 1' positioniert werden, um den Dichtstrang 1' zu strecken und dabei sein Profil zu ändern.

Die elektromagnetische Platte 7 wird nun kurzzeitig an eine Stromquelle (nicht dargestellt) angeschlossen. Aufgrund der in dem noch plastischen, verformbaren Dichtstrang 1' befindlichen magnetischen Teilchen 2, das heißt, der in die aushärtbare Masse eingebetteten silberummantelten magnetischen Partikel, und der auf diese wirkenden, von den Elektromagneten 10 der elektromagnetischen Platte 7 ausgehenden magnetischen Anziehungskräfte wird das magnetische Dichtungsmaterial an die elektromagnetische Platte 7 bzw. an oder in die an deren unterer Fläche verlaufende Profilierung 8 gezogen. Wie die Figuren 1 bis 4 zeigen ist somit eine bestimmte Höhe der Dichtung 1 individuell einstellbar, das heißt, der Dichtstrang 1' für die Dichtung 1 kann in der Höhe gestreckt und damit elastischer ausgebildet werden, und in dem zur Dichtfläche des gegenüberliegenden Gehäuseteils weisenden Bereich der Dichtung 1 kann eine bestimmte, höherelastische Profilierung ausgeformt werden. Diese Formgebung ist möglich, weil zu diesem Zeitpunkt nur der Oberflächenbereich des Dichtstranges 1' ausgehärtet ist und aufgrund seiner Flexibilität den Verformungskräften folgen kann, während der weit überwiegende Teil der elastisch aushärtenden Dichtstoffmasse noch plastisch verformbar ist und andererseits die magnetischen Teilchen 2 im Randbereich (Außenring 3) gebunden sind.

Nach der Höheneinstellung und Formgebung (Streckung und Profilierung) des Dichtstranges 1' wird die elektromagnetische Platte 7 von der fertigen Dichtung 1 gelöst. Die elektromagnetische Platte 7 ist insofern leicht von der Dichtung 1 lösbar, als zumindest deren Oberfläche zum Zeitpunkt der Verformung bereits ausgehärtet war und an der elektromagnetischen Platte 7 nur aufgrund der Magnetkräfte gehalten wurde. Andererseits ist die Dichtung 1 zum Zeitpunkt des Lösens der elektromagnetischen Platte 7 soweit ausgehärtet, dass sie die aufgrund der Magnetkräfte erzeugte Form auch beibehält. Um die Aushärtung des Dichtungsmaterials zu beschleunigen und damit die Verformung aufgrund der magnetischen Kräfte zu stabilisieren, kann bei einem unter Wärmeeinfluss aushärtenden Material eine Wärmezufuhr über die elektromagnetische Platte 7 erfolgen.

In Fig. 1 ist in der linken Bildhälfte ein frisch extrudierter Dichtstrang 1' mit einer nahe über diesem positionierten elektromagnetischen Platte 7 gezeigt. Die Profilierung 8 an der Unterseite der elektromagnetischen Platte 7 ist eine annähernd halbkreisförmige Nut. Der mittlere Teil der Fig. 1 zeigt die Dichtung 1 in der an die elektromagnetische Platte angezogenen bzw. in die Profilierung 8 eingezogenen Ausbildung. In dem rechten Bildteil ist schließlich die fertige Dichtung 1 in der vorbestimmten (gestreckten) Höhe und mit schmalerem und daher höherelastischem oberen Teil (Dichtlippe 9) dargestellt. Eine vergleichbare Ausführungsvariante, jedoch mit zwei nebeneinander verlaufenden sowie im Wesentlichen spitz zusammenlaufenden Dichtlippen 9, ist in Fig. 2 wiedergegeben. In diesem Fall besteht die Profilierung 8 in der elektromagnetischen Platte 7 (bzw. dem Elektromagneten 10) aus zwei dreieckförmig ausgebildeten Einschnitten.

Eine tropfenartige, nach oben spitz zulaufende Form (nicht dargestellt) lässt sich auch mit einer elektromagnetischen Platte mit ebener Unterseite (ohne Profilnut) erzielen, wenn die elektromagnetische Platte 7 in einem bestimmten Abstand oberhalb des extrudierten, noch runden Dichtstranges 1' positioniert wird. Abweichend von diesen Ausführungsbeispielen kann die elektromagnetische Platte 7 mit Profilierung 8 auch unmittelbar auf der Dichtung angeordnet werden, um die Streckung nur über die angeformte Dichtlippe 9 zu bewirken. Gleichermaßen ist es denkbar, durch Absenken der elektromagnetischen Platte eine abgeflachte Form der Dichtung 1, und zwar mit oder ohne Dichtlippe, zu erzeugen oder die Streckung des Querschnitts in der Höhe durch Anheben der unmittelbar auf den Dichtstrang 1' aufgesetzten elektromagnetischen Platte zu bewirken.

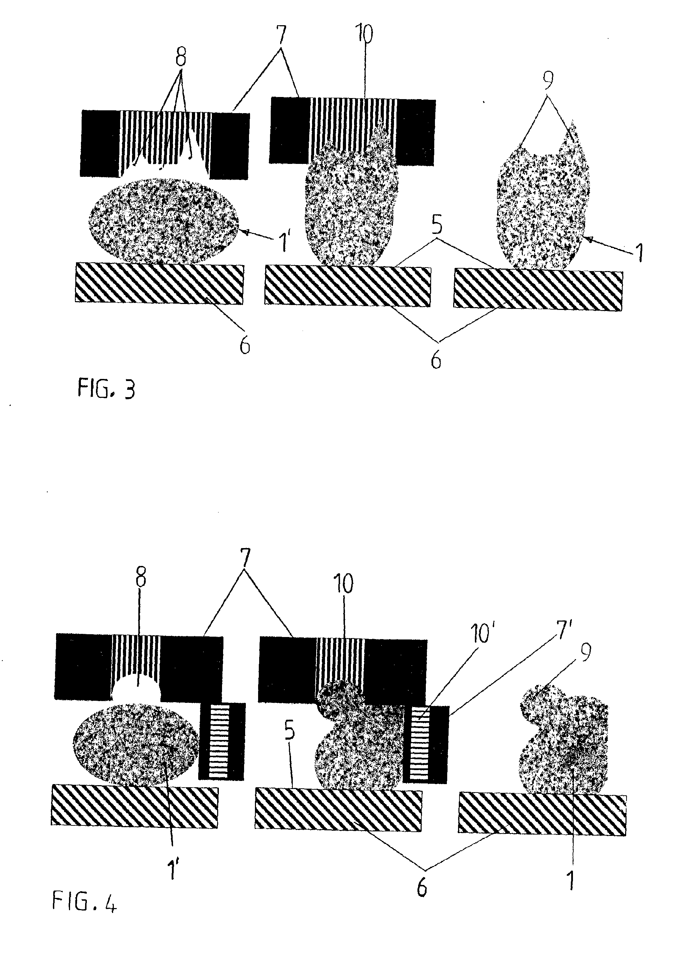

Die Figuren 3, 4 und 5 zeigen weitere Ausführungsvarianten der Herstellung einer Dichtung 1 mit unterschiedlich profilierten, einfachen oder doppelten Dichtungslippen 9, wobei die Dichtung jeweils um die Höhe der Dichtungslippe(n) 9 nach oben gestreckt ist, um durch das Strecken und Profilieren des Dichtstranges 1'wird nicht nur die Elastizität der Dichtung in diesem Bereich erhöht, sondern es können auch durch das Auftragen des Dichtungsmaterials und durch das abzudichtende Gehäuse bedingte Höhenunterschiede ausgeglichen werden, um eine bestimmte, einheitliche Höhe der Dichtung 1 festlegen zu können und auch ohne zwei- oder mehrfaches Übereinanderlegen von extrudierten Dichtungssträngen eine vorgegebene große Höhe der Dichtung bei geringem Materialaufwand zu erreichen.

Fig. 4 zeigt eine weitere Ausführungsvariante der Erfindung, bei der nicht nur die Querschnittshöhe gestreckt und eine Dichtlippe 9 angeformt wird, sondern die Querschnittsform des Dichtstranges 1' auch in seitlicher Richtung beeinflusst wird, und zwar durch eine seitlich angeordnete und verfahrbare elektromagnetische Platte 7' mit Elektromagneten 10'.

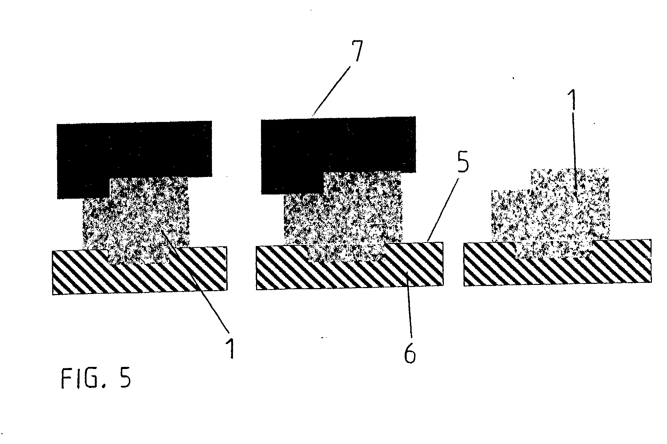

In der in Fig. 5 dargestellten Ausführungsform ist die elektromagnetische Platte mit einer Stufe ausgebildet, wobei einen hier beispielhaft rechteckigen Dichtstrang 1' an die elektromagnetische Platte 7 heranzuziehen und dabei eine bestimmte, stufenartige ausgeprägte Dichtung 1 zu erzeugen. Gleichermaßen kann diese elektromagnetische Platte 7 auf den Dichtstrang 1' gepresst werden, um eine seitliche Streckung des Dichtstranges 1' zu bewirken und eine entsprechend abgeflachte und profilierte Dichtung 1 zu erzeugen.

### Bezugszeichenliste

- 1: Dichtung,
- 1': Extrudierter Dichtstrang
- 2: Magnetische Teilchen, leitende Teilchen
- 3: Leitfähiger, magnetischer Außenring
- 4: Leitmittelfreier Innenstrang
- 5: Erste Dichtfläche
- 6: Gehäuseteil (mit erster Dichtfläche)
- 7: Elektromagnetische Platte
- 7': seitliche elektromagnetische Platte
- 8: Profilierung (Einschnitt/Erhöhung/Stufe)
- 9: Dichtlippen
- 10: Elektromagnet(segment)
- 10': Elektromagnet(segment)

## Patentansprüche

1. Verfahren zur Herstellung einer elektrisch leitfähigen Dichtung aus mit elektrisch leitenden Partikeln vermischtem, elastisch aushärtenden Material, das aus einem Extruder in noch plastischem Zustand unmittelbar auf eine erste Dichtfläche aufgetragen wird, **dadurch gekennzeichnet, dass** in das Dichtungsmaterial vor der Extrusion magnetische Teilchen eingemischt werden und nach dem Aufbringen des Dichtungsmaterials auf die erste Dichtfläche (5) und dem anschließenden Aushärten nur einer Oberflächenschicht mit einer oberhalb des extrudierten Dichtstranges (1') angeordneten elektromagnetischen Platte (7) über einen bestimmten Zeitraum ein magnetisches Feld erzeugt wird und der an der Dichtfläche (5) haftende Dichtstrang (1') aufgrund der auf die magnetischen Teilchen wirkenden Magnetkräfte zur elektromagnetischen Platte (7) hin gestreckt und zu der fertigen Dichtung (1) verformt wird.

2. Verfahren nach Anspruch 1, **dadurch gekennzeichnet, dass** die elektromagnetische Platte (7) auf eine der jeweiligen Dichtspalthöhe entsprechende Höhe im Abstand oberhalb des auf die Dichtfläche (5) extrudierten Dichtstranges (1') eingestellt wird und der Querschnitt des Dichtstranges (1') zur Formgebung der fertigen Dichtung (1) auf diese Höhe gestreckt wird.

3. Verfahren nach Anspruch 1, **dadurch gekennzeichnet, dass** die elektromagnetische Platte (7) auf den extrudierten Dichtstrang (1') aufgesetzt und dessen Querschnittsform durch eine begrenzte Aufwärtsbewegung der elektromagnetischen Platte (8) auf eine bestimmte gleichmäßige Höhe der fertigen Dichtung (1) eingestellt wird.

4. Verfahren nach einem der Ansprüche 1 bis 3, **dadurch gekennzeichnet, dass** der Dichtstrang (1') als einschichtige Lage auf die Dichtfläche (5) aufgetragen wird und auf die gewünschte Höhe zum Ausfüllen des Dichtspaltes gestreckt wird.

5. Verfahren nach einem der Ansprüche 1 bis 4, **dadurch gekennzeichnet, dass** durch eine in die elektromagnetische Platte (7) eingeschnittene, dem Verlauf der Dichtung (1) folgende nutartige Profilierung (8) an dem freien Abdichtbereich der Dichtung (1), der zu einer gegenüberliegenden zweiten Dichtfläche weist, elastische Dichtungslippen (9) magnetisch ausgeformt werden.

6. Verfahren nach einem der Ansprüche 1 bis 5, **dadurch gekennzeichnet, dass** Dichtungsmaterial ein bei Raumtemperatur oder bei erhöhter Temperatur oder unter UV-Strahlung elastisch aushärtendes Material ist.

7. Verfahren nach Anspruch 6, **dadurch gekennzeichnet, dass** bei einem unter erhöhter Temperatur aushärtenden Material die Wärmezufuhr über die elektromagnetische Platte (7) durchgeführt wird.

8. Verfahren nach einem der Ansprüche 1 bis 7, **dadurch gekennzeichnet, dass** die magnetisch in der Höhe gestreckte und verformte Dichtung (1) bis zum Erreichen der Formstabilität durch die Magnetkräfte oder mit Hilfe eines Vakuums an der elektromagnetischen Platte (7) gehalten wird.

9. Verfahren nach einem der Ansprüche 1 bis 8, **dadurch gekennzeichnet**, das als leitende und als magnetische Teilchen mit einer elektrisch leitenden Schicht überzogene einstückige Partikel oder Nickelpartikel, die sowohl elektrisch leitend als auch magnetisch sind, oder leitfähige magnetische und leitfähige nicht magnetische Partikel vor der Extrusion in das Dichtungsmaterial eingemischt werden.

10. Verfahren nach Anspruch 9, **dadurch gekennzeichnet, dass** die elektrisch leitende Schicht aus Silber besteht und die magnetischen Teilchen aus Eisen oder Nickel oder einem anderen magnetischen Material sind.

11. Verfahren nach einem der Ansprüche 1 bis 10, **dadurch gekennzeichnet, dass** die einstückigen elektrisch leitenden und magnetischen Teilchen zur Erzielung einer hohen Leitfähigkeit und magnetischen Wirkung und zur Verringerung des diesbezüglichen Materialaufwandes am Umfangsrandbereich der auf die Dichtfläche (5) extrudierten Dichtung (1) konzentriert werden, indem bei der Extrusion am Umfang des Dichtungsstranges abschnittsweise und zeitlich voneinander unabhängige Magnetkräfte erzeugt werden, die die leitenden und magnetischen Teilchen an den Außenrand der Dichtung zieht, um einen leitfähigen, magnetischen Randbereich und einen hochelastischen Innenstrang zu schaffen.

12. Verfahren nach einem der Ansprüche 1 bis 10, **dadurch gekennzeichnet, dass** ein Dichtungsmaterial, das mit einstückig ausgebildeten leitenden und magnetischen Teilchen oder mit separaten leitend und magnetisch wirkenden Teichen vermischt ist, und ein von leitenden und magnetischen Teilchen freies Dichtungsmaterial durch Koextrusion als Dichtstrang (1') aufgetragen werden, wobei das mit magnetisch und leitend wirkenden Teilchen vermischte Dichtungsmaterial das von Zusätzen freie Dichtungsmaterial als überzugartige Hülse umgibt.

13. Verfahren nach Anspruch 12, **dadurch gekennzeichnet, dass** zur Verringerung der Extrusionsdrücke dem Außenstrang ein verminderter Anteil an leitfähigen magnetischen Teilchen und dem hochelastischen Innenstrang der restliche Anteil an leitfähigen magnetischen Teilchen, die beim Extrudieren magnetisch in den Außenrand gezogen werden, zugemischt wird.

14. Verfahren nach einem der Ansprüche 1 bis 13, **dadurch gekennzeichnet, dass** leitfähige und magnetische Teilchen in Form von Fasern oder Plättchen verwendet werden.

15. Verfahren nach einem der Ansprüche 1 bis 11, **dadurch gekennzeichnet, dass** der Dichtstrang (1') als Hohlstrang auf die Dichtfläche aufgetragen wird und das Querschnittsprofil in dieser Form durch die Magnetkräfte der elektromagnetischen Platte gehalten und weiter gestreckt und/oder profiliert wird.

16. Verfahren nach einem der Ansprüche 1 bis 15, **dadurch gekennzeichnet, dass** die Querschnittsfläche des Dichtstranges (1') durch die magnetischen Kräfte einer seitlich angeordneten und verfahrbaren elektromagnetischen Platte (7')verformt wird.

17. Vorrichtung zur Durchführung des Verfahrens nach Anspruch 1, mit einem entsprechend dem Kurvenverlauf einer Dichtfläche über dieser beweglichen Extruder zur Ausgabe des Dichtungsmaterials auf eine erste Dichtfläche, **gekennzeichnet durch** eine seitlich und in der Höhe verfahrbare elektromagnetische Platte (7), die zur Erzeugung eines Magnetfeldes zeitlich begrenzbar an eine Stromquelle angeschlossen ist und die in einer bestimmten Höhe auf oder im Abstand oberhalb des extrudierten Dichtstranges (1') positionierbar ist.

18. Vorrichtung nach Anspruch 17, **dadurch gekennzeichnet, dass** die elektromagnetische Platte (7) an ihrer der Dichtung zugewandten Seite eben ausgebildet ist oder eine Profilierung (8) in Form von mindestens einer dem Dichtungsverlauf entsprechenden Erhöhung/Vertiefung aufweist.

19. Vorrichtung nach Anspruch 17, **dadurch gekennzeichnet, dass** die Profilierung (8) zum Ausgleich von Abstufungen der Dichtflächen des Gehäuses entsprechend unterschiedlich dimensioniert ist.

20. Vorrichtung nach Anspruch 18 oder 19, **dadurch gekennzeichnet, dass** im Verlauf der Profilierung (8) aufeinanderfolgende Elektromagnetsegmente (10) ausgebildet sind, die mit unterschiedlicher Magnetkraft zeitlich ansteuerbar sind.

21. Vorrichtung nach Anspruch 17, **dadurch gekennzeichnet, dass** die elektromagnetische Platte (7) auf der dem zu verformenden Dichtstrang (1') zugewandten Seite mit einem Trennmittel beschichtet ist.

22. Dichtung zur elektromagnetischen und stofflichen Abdichtung zwischen einer ersten und einer zweiten Dichtfläche, bestehend aus einem unmittelbar auf die erste Dichtfläche extrudierten und an dieser haftenden, elastisch aushärtenden Material mit in diesem vermischten elektrisch leitfähigen Teilchen, hergestellt nach dem Verfahren des Anspruchs 1, **dadurch gekennzeichnet, dass** in dem elastisch aushärtenden Dichtungsmaterial magnetische Teilchen enthalten sind und die Dichtung zur Verbesserung der Dichtwirkung und zum Ausgleich von Höhentoleranzen des Dichtspaltes und des frisch extrudierten Dichtstranges (1') eine in Richtung zu den Dichtflächen gestreckte Querschnittsform aufweist.

23. Dichtung nach Anspruch 22, **dadurch gekennzeichnet, dass** auf ihrer zur zweiten Dichtfläche weisenden Seite mindestens eine Erhöhung und/oder Vertiefung zur Ausbildung mindestens einer hochelastischen Dichtlippe (9) ausgeformt ist.

24. Dichtung nach Anspruch 22 oder 23, **dadurch gekennzeichnet, dass** das elastische Material für die Dichtung gummi- oder schaumelastisch ist und bei Raumtemperatur, erhöhter Temperatur oder unter der Wirkung von UV-Strahlen aushärtet.

25. Dichtung nach einer der Ansprüche 22 bis 24, **dadurch gekennzeichnet, dass** die leitenden Teilchen und die magnetischen Teilchen einstückige Partikel aus einem mit Silber beschichteten Kern aus Eisen- oder Nickel oder einem anderen magnetischen Material oder nur aus Nickel bestehende Partikel sind oder jeweils separate leitende Partikel und magnetische Partikel umfassen.

26. Dichtung nach einem der Ansprüche 22 bis 24, **dadurch gekennzeichnet, dass** die separat oder einstückig leitend und magnetisch ausgebildeten Teilchen am Umfangsrand der Dichtung (1) konzentriert sind.
